# EUROPEAN PATENT APPLICATION

(11) **EP 2 489 960 A1**
(43) Date of publication of application: **22.08.2012**
(21) Application number: 10826131.4
(22) Date of filing: 08.10.2010
(51) Int. Cl.: F24J 2/18, H01L 31/052

(54) **SOLAR-ENERGY COLLECTOR/CONCENTRATOR, WITH CASSEGRAIN-TYPE OPTICS**

(30) Priority: 15.10.2009 ES 200901434 U
(71) Applicant: Soltec Energías Renovables, SL, 30500 Molina de Segura (Murcia) (ES)
(72) Inventor: GRANT, Thomas, E-03380 Bigastro (Alicante) (ES); TERUEL HERNÁNDEZ, José Alfonso, E-30167 La Raya (Murcia) (ES); MORALES TORRES, Raúl, E-30500 Molina de Segura (Murcia) (ES)
(74) Representative: Torner Lasalle, Elisabet
(86) International application number: PCT/ES2010/000408
(87) International publication number: WO 2011/051510

(57) **Abstract**

The collector/concentrator includes a primary concave reflector (1) supported on a base body (3) obtained by injection moulding, which defines a central support (5) supporting a region around a central opening (6) of the primary reflector (1), a plurality of peripheral legs (7) supporting respective peripheral regions of the primary reflector (1) and first integral connection members (8) connecting said peripheral legs (7) with said central support (5). The peripheral legs (7) have bottom ends (7a) leaning on a substantially flat supporting surface and top ends (7b) located above said peripheral regions of the primary reflector (1) that are in contact with a substantially flat transparent panel (15) supporting a secondary convex reflector (2) that concentrates the solar radiation reflected by the primary reflector (1) towards a receiver unit (18) through said central opening (6).

## Description

### Field of the art

The present invention relates to a solar energy collector/concentrator with Cassegrain-type optics wherein the primary and secondary reflectors comprise a plastic substrate obtained by injection moulding and afterwards metallised, and the secondary reflector is supported by a base likewise obtained by injection moulding of a plastic material.

### Background of the invention

Solar energy collector/concentrators provided with a Cassegrain-type optical system for concentrating the solar radiation captured through a collector of relatively large dimensions in a receiver of relatively small dimensions are well known. In this type of collector/concentrator, the collector is a primary concave reflector that is arranged to reflect and concentrate the captured solar radiation towards a secondary smaller convex reflector, which is located above the primary reflector and arranged in turn to reflect and concentrate the solar radiation from the primary reflector towards the receiver through a central opening existing in the primary reflector. The collector can be a device for the exploitation of thermal energy or a photovoltaic cell for converting solar energy into electricity.

The Cassegrain optical system is advantageous in that it allows for a high concentration ratio between the collector area and the receiver area, of up to 1400/1 or more, with a small focal length, which allows for the procurement of solar energy collector/concentrators of a relatively small volume and high performance. Nevertheless, it requires that the primary and secondary reflectors be made and positioned within strinct tolerances in order to prevent the spreading of the reflected radiation and loss of performance. Using a radiation guide interposed between the secondary reflector and the collector is known to compensate for possible element orientation errors. This radiation guide acts by redirecting and homogenising the radiation entering therein to provide a good energy distribution on the collector. On the other hand, the radiation concentration causes a considerable temperature rise in the collector and regions adjacent thereto, which forces the provision of cooling means.

International Patent Application WO 2006/030433 discloses a collector/concentrator with a Cassegrain-type optical system wherein the primary reflector comprises a structural plastic substrate with a metallised layer, the primary reflector being supported by a base that covers a small area around said central opening of the primary reflector. The base is configured to further support a plate on which a photovoltaic cell is mounted. The same base defines a radiation guide, in the shape of a tube with inner reflective walls, that is interposed between the primary reflector and the photovoltaic cell, and a chamber surrounding the radiation guide and part of the plate on which the photovoltaic cell is mounted. Said chamber is in communication with a cooling fluid inlet and outlet. In one embodiment, a plurality of collector/reflector units, which have a square floor plan configuration in their primary reflector, are arranged as an array to form a solar energy collector/concentrator module. The module collector/reflector units are housed in an enclosure that has a number of side walls connected to a bottom wall, on which the bases of the primary reflectors of the collector/reflector units lean, and to a closure glass that supports the secondary reflectors.

A drawback of the collector/concentrator of the cited International Patent Application WO 2006/030433 is that the base does not guarantee an accurate positioning of the primary reflector, since it only covers a small central region thereof, which may be the cause of orientation errors and loss of effectiveness, specially when the collector/concentrator units are clustered together in one prefabricated module. Another drawback is that the cooling system made up by a chamber in communication with a cooling fluid circuit is complex and costly to manufacture and it requires regular maintenance.

The art of making the primary reflector with a structural plastic substrate is also described in US-A-5365920 and US-A-5062899.

US-A-2009101207 describes a solid frustopyramidal radiation guide made of a transparent material to guide light from the secondary reflector to the photovoltaic cell.

International Patent Application WO 2006130520 describes a concentrator wherein the plate on which the photovoltaic cell is mounted is attached to the base plate, which operates to dissipate heat from the photovoltaic cell into the atmosphere.

International Patent Application WO 2009058603, which is regarded as the closest precedent, discloses a solar collector/concentrator system comprising a transparent panel that provides a substantially flat surface, a primary concave reflector for reflecting solar radiation whose first perimeter has a substantially square floor plan and at least one portion of said first perimeter is in contact with said substantially flat surface, a secondary convex reflector for reflecting solar radiation, coming from the primary reflector, whose second perimeter has a substantially square floor plan and at least one portion of said second perimeter is in contact with the substantially flat surface, and a reflector positioned to receive the solar radiation reflected by said secondary reflector. The fact of having the primary reflector directly in contact with the transparent panel has the drawback of introducing mechanical loadings potentially harmful to the system. The weight of the primary reflector itself or its interaction with other parts for which it acts as a support might produce undesirable deformations in the transparent panel or shorten its lifetime, diminishing the concentrator performance.

### Disclosure of the invention

The present invention contributes to overcoming the above and other drawbacks by providing a solar energy collector/concentrator with Cassegrain-type optics, including at least one collector/concentrator unit comprising a primary concave reflector arranged to reflect solar radiation, a secondary convex reflector supported by a substantially flat transparent panel above said primary reflector and arranged to reflect said solar radiation from the primary reflector, and a receiver unit arranged to receive the solar radiation reflected by said secondary reflector through a central opening formed in the primary reflector. The collector/concentrator of the present invention is characterised in that the primary reflector is supported on a base body obtained by injection moulding, for example a plastic material, which defines a central support configured to support a region around said central opening of the primary reflector, a plurality of peripheral legs configured to support respective peripheral regions of the primary reflector and first integral connection members connecting said peripheral legs with said central support. The peripheral legs have bottom ends configured to lean on a substantially flat supporting surface and top ends located above said peripheral regions of the primary reflector and configured to be in contact with and attached to said transparent panel, for example by means of an adhesive.

By virtue of the peripheral leg ends, the base body is capable of supporting the primary reflector in a very stable manner on said supporting surface and, at the same time, positioning the primary reflector relative to the transparent panel, with the secondary reflector being supported thereon. The base body maintains the primary reflector free from mechanical loads, thus ensuring the integrity of the geometry thereof and preventing its premature aging. In addition, the base body can be linked to a base panel providing said supporting surface.

Preferably, the base body further comprises second connection members connecting the mutually adjacent peripheral legs, both the first and second connection members having respective top edges configured to be in contact with an underside of the primary reflector, whereby the primary reflector is very well seated on the base body. In one preferred embodiment, the primary reflector comprises a structural substrate obtained by injection moulding of a plastic material, which is metallised, for example with silver o aluminium, on the concave surface thereof. Manufacturing the structural substrate of the primary reflector and the base body as two separate pieces has the advantage of minimising the irregularities on the reflective surface, since the moulded configurations on the side of structural substrate opposite the reflective surface might cause undesirable deformations therein, and, in addition, it allows for manufacturing both pieces with different plastic materials, for example a more resistant and stable plastic material for the structural substrate and a more common material for the base body.

The fact that the structural substrate of the primary reflector and the base body should be separate pieces obtained by injection moulding of a plastic material further allows for the formation of the structural substrate and the base body with respective mutual snap lock first coupling configurations in said region around the central opening of the primary reflector and on the central support of the base body and respective mutual snap lock second coupling configurations in said peripheral regions of the primary reflector and in the peripheral legs of the base body. Thus, the assembly of the primary reflector to the base body can be carried out in an easy, fast manner, without the use of tools, and with complete reliability regarding mutual positioning. Preferably, the secondary reflector also comprises a structural substrate obtained by injection moulding of a plastic material with metallisation of the convex surface thereof, and it is attached to the transparent panel, for example by means of an adhesive.

In order to optimise the space when there is the desire to form a solar energy collector/concentrator module including a plurality of collector/concentrator units, the primary reflector of each unit has a polygonal floor plan defining a number of vertexes, which, as a result of the concave shape of the primary reflector, are located in the topmost points of the perimeter thereof. Correspondingly, the base body comprises the same number of peripheral legs configured and arranged such that every peripheral leg supports one of the vertexes of the primary reflector. Preferably, the primary reflector has a square floor plan defining four vertexes and the base body comprises four peripheral legs, although other geometries are possible. Preferably, when the primary reflector has a square floor plan, the secondary reflector also has a square floor plan.

Said receiver unit can include a device for the exploitation of thermal energy, although it preferably comprises a photovoltaic cell mounted together with electric and electronic components, on a receiver plate. In such a case, the central support of the base body is configured to support said receiver plate in such a position that the photovoltaic cell is facing said secondary reflector through said central opening of the primary reflector and a back surface of the receiver plate is in contact with a base panel providing said substantially flat supporting surface to dissipate heat from the receiver plate to said base panel. In addition, the receiver unit preferably comprises a radiation guide supported on said receiver plate and drawn through the central opening of the primary reflector to remain interposed between the secondary reflector and the photovoltaic cell. This radiation guide can be a tubular conduit with inner reflective walls, although it is preferred that the radiation guide comprise a solid frustopyramidal block made of a transparent material, such as for example BK7 glass. For the securement and positioning of the radiation guide, the latter may have for example a base surface attached to the photovoltaic cell by means of a transparent adhesive.

In one preferred embodiment, the collector/concentrator comprises a plurality of said collector/concentrator units arranged as an array and housed in an enclosure comprising side walls attached to a base panel that provides the substantially flat surface on which said bottom ends of the peripheral legs of the base bodies of the primary reflectors lean, and to said substantially flat transparent panel leaning on said top ends of the peripheral legs of the base bodies of the primary reflectors and on which the secondary reflectors are supported. In addition, the receiver plates on which the photovoltaic cells are mounted are in contact with the base panel of the enclosure so as to dissipate heat from the receiver plates to the base panel, the latter being made of a metallic material with a high thermal conductivity coefficient and, preferably, having attached a number of outer thermal dissipation fins. Optionally, the side walls of the enclosure are also made of a metallic material with a high thermal conductivity coefficient and are sufficiently in contact with the base panel to receive heat from the base panel and dissipate it into the atmosphere. For example, one or more of the side walls of the enclosure may be integrally formed with the bottom panel for more efficient thermal transfer. Optionally, the side walls of the enclosure may also have attached a number of thermal dissipation fins. The transparent panel of said enclosure optionally comprises an antireflection treatment on one or both sides thereof.

The particular construction of the solar energy collector/concentrator of the present invention allows for an optimisation of the optical system that provides the following parameters:
- a geometric concentration defined as the ratio of an aperture surface of the primary reflector and a receiver surface of the photovoltaic cell, comprised in the range of 1470/1 to 1490/1;
- a ratio of the floor plan area of the primary reflector to the floor plan area of the secondary reflector, comprised in the range of 42/1 to 44/1;
- a ratio of the floor plan area of the primary reflector to the distance between the primary reflector and the secondary reflector, measured along the optical axis, comprised in the range of 655/1 to 685/1; and
- an acceptance angle of ±1° or larger.

### Brief description of the drawings

The above and other features and advantage will be apparent from the following detailed description of an embodiment with reference to the appended drawings, wherein:
Fig. 1 is a perspective view of a solar energy collector/concentrator unit with Cassegrain-type optics according to one embodiment of the present invention;
Fig. 2 is a cross section taken along a central, vertical plane parallel to one of the sides of the collector/concentrator unit of Fig. 1, with a magnified detail;
Fig. 3 is an exploded perspective view of a primary reflector and a base body that are part of the collector/concentrator unit of Fig. 1, with a magnified detail;
Fig. 4 is a bottom perspective view of the assembled primary reflector and base body, with a magnified detail;
Fig. 5A is an enlarged exploded perspective view of a receiver plate, a photovoltaic cell, a radiation guide and a guide support that are part of the collector/concentrator unit;
Fig. 5B is a perspective view of the assembled collector/concentrator unit of Fig. 5A;
Fig. 6 is a top perspective view of the assembled primary reflector and base body, with a magnified detail;
Fig. 7 is a perspective view of a solar energy collector/concentrator unit according to another embodiment of the present invention including a plurality of collector/concentrator units analogous to that of Fig. 1, with a magnified detail;
Fig. 8 is an exploded perspective view of the collector/concentrator of Fig. 7; and
Fig. 9 is a cross sectional view taken along a vertical plane across the centre of a row of collector/concentrator units and parallel to one of the sides of the collector/concentrator unit of Fig. 7.

### Detailed description of exemplary embodiments

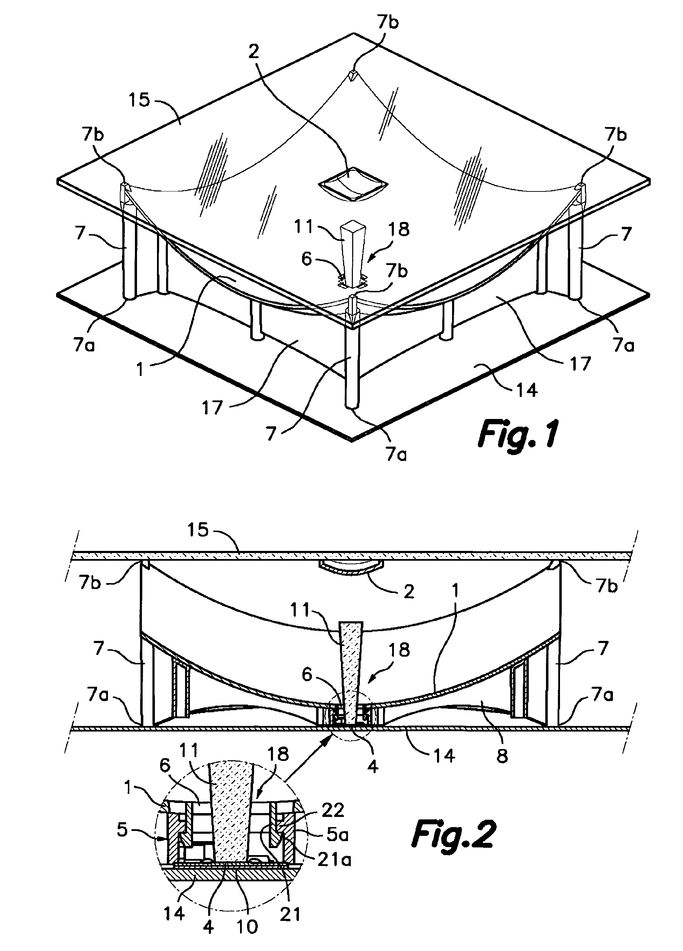

Referring first to Figs. 1 to 6, there is shown a solar energy collector/concentrator unit with Cassegrain-type optics according to one embodiment of the present invention that comprises a primary concave reflector 1 supported on a base body 3 that leans on a substantially flat supporting surface, provided, for example, by a base panel 14, a secondary convex reflector 2 supported by a substantially flat transparent panel 15 above said primary reflector 1, and a receiver unit 18 arranged below said primary reflector and opposite said secondary reflector 2 through a central opening 6 formed in the primary reflector 1.

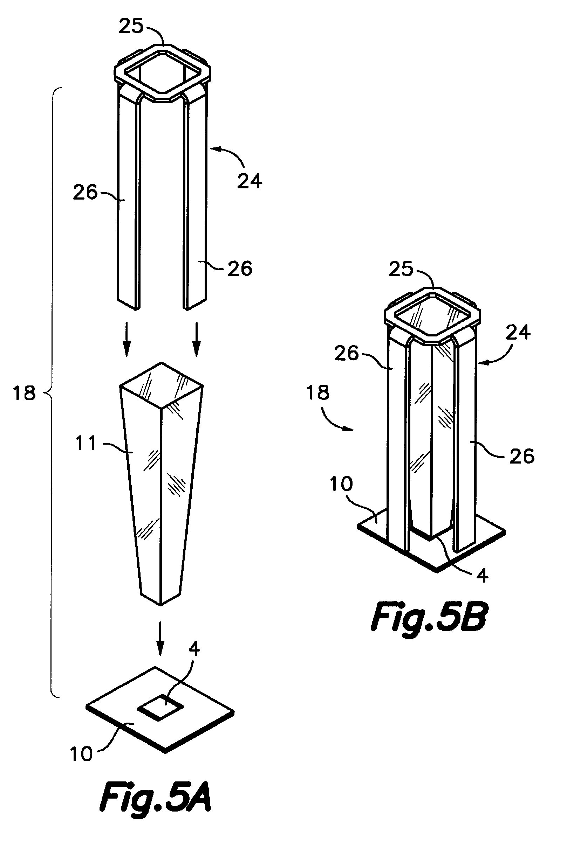

As shown in Figs. 2, 5A and 5B, said receiver unit 18 comprises a photovoltaic cell 4 mounted, together with electric and electronic components, on a receiver plate 10. The receiver unit 18 also comprises a radiation guide 11 in the shape of a solid frustopyramidal block made of a transparent material, such as, for example, BK7 glass, and it has a base surface attached to a top surface of the photovoltaic cell 4 by means of a transparent adhesive. In an operating situation (Figs. 1 and 2), the radiation guide 11 is drawn through said central opening 6 of the primary reflector 1 and it remains interposed between the secondary reflector 2 and the photovoltaic cell 4. Alternatively, the radiation guide 11 can be supported in the selfsame position by other means; for example, attached to said receiver plate 10 through mechanical means with an equivalent result. In some cases, the radiation guide 11 might be omitted, although this would negatively affect the performance of the collector/concentrator unit. In the embodiment illustrated in Figs. 5A and 5B, the receiver unit 18 further comprises a guide support 24 defining a top frame 25 that leans on the edges of the top side of said radiation guide 11 and a number of legs 26 extending downwards from said top frame 25, and having their bottom ends attached to said receiver plate 10. Alternatively, the bottom ends of the legs 26 can be directly attached to the base body 3. This guide support 24 is optional and it serves for securing the radiation guide 11 to the photovoltaic cell 4 and for its relative positioning.

As is conventional, in the solar energy collector/concentrator of the present invention provided with Cassegrain-type optics, the primary reflector 1 constitutes a receiver and is configured and arranged to reflect the received solar radiation towards the secondary receiver 2, and the latter is configured and arranged to reflect said solar radiation coming from the primary reflector 1 towards the photovoltaic cell 4 through the radiation guide 11. The photovoltaic cell 4 transforms the energy of the solar radiation into electricity, which is led outside the receiver/concentrator by means of suitable wiring (not shown).

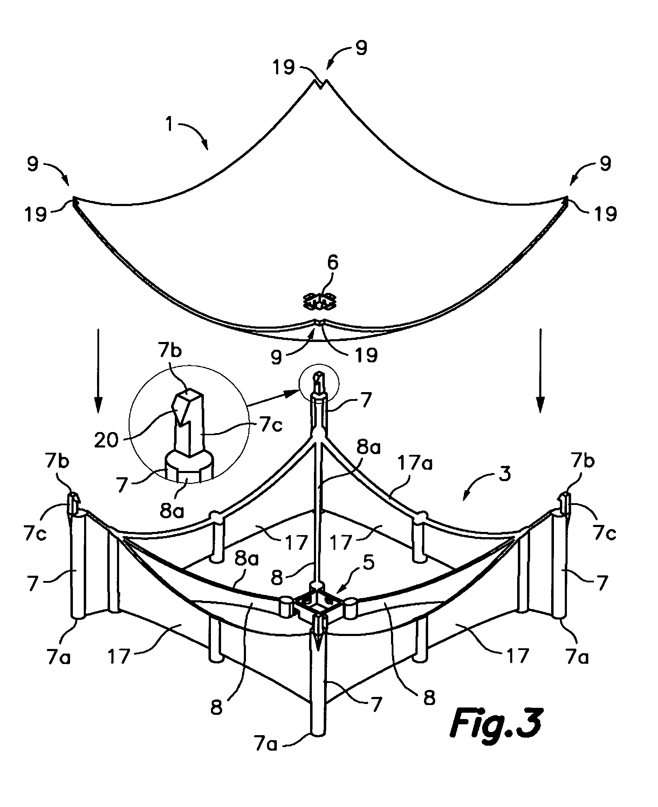

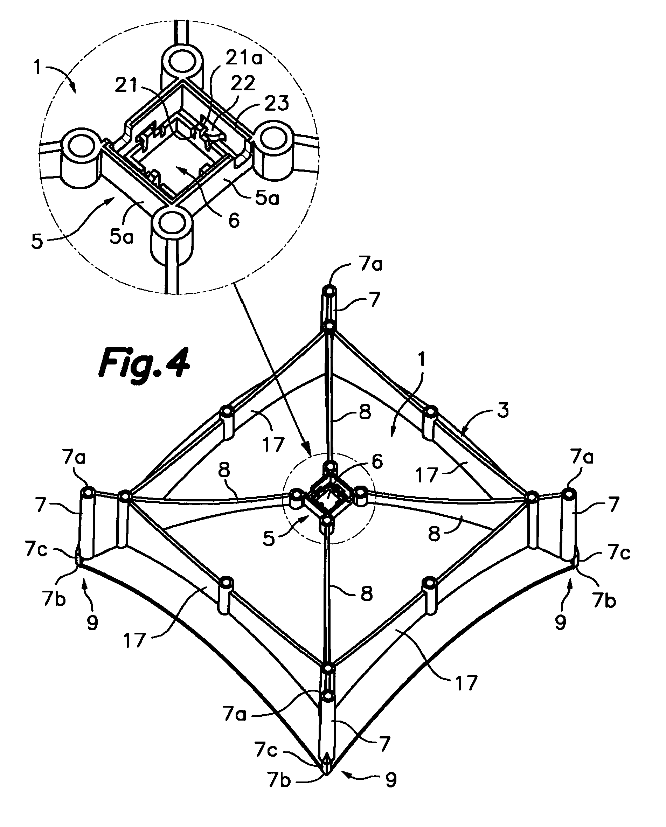

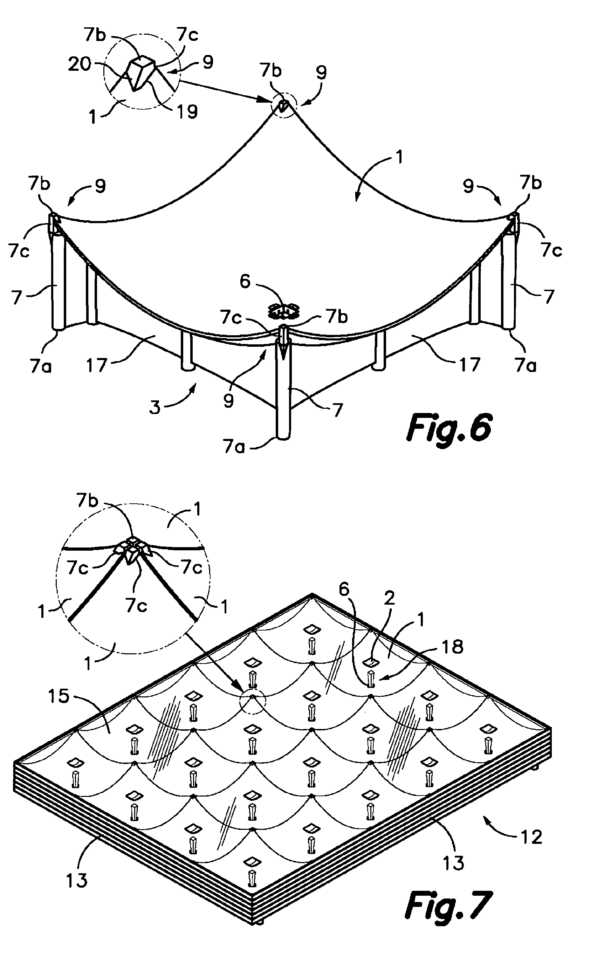

The primary reflector 1 is formed by a structural substrate obtained by injection moulding of a plastic material that defmes a concave surface and one or more metallised layers, for example of aluminium or silver, on said concave surface of the structural plastic substrate. Said base body 3, on which the primary reflector 1 is supported, is formed by one monolithic body obtained by injection moulding, preferably of a plastic material, that defines a central support 5 configured to support a region around said central opening 6 of the primary reflector 1 and a plurality of peripheral legs 7 configured to support respective peripheral regions of the primary reflector 1. First connection members 8, integral with the base body 3, connect said peripheral legs 7 with said central support 5, and second connection members 17, also integral with the base body 3, connect the mutually adjacent peripheral legs. These first and second connection members 8, 17 have respective top edges 8a, 17a (Fig. 3) configured to be in contact with an underside of the primary reflector 1 when the primary reflector 1 and the base body 3 are assembled in an operating situation (Figs. 4 and 6).

For the mutual coupling of the primary reflector 1 and the base body 3 snap lock coupling means have been envisaged, which do not require the use of tools, that are provided by first and second coupling configurations that are formed integrally in the structural substrate of the primary reflector 1 and the base body 3 during the injection moulding process of the respective plastic materials.

As shown best in Fig. 3, in said peripheral regions of the primary reflector 1, a number of notches 19 are formed configured to fit in upper portions 7c of the peripheral legs 7, under first retaining claws 20 formed thereon. Said first retaining claws 20 have a sloping top surface. This way, when the primary reflector 1 is placed on the base body 3 with said notches 19 aligned with the upper portions 7c of the peripheral legs 7 and is pressed downwards, the primary reflector experiences a deformation and subsequent elastic recovery sufficient for the notches 19 to get past the retaining claws 20 and become grasped thereby (Fig. 6), contributing to keeping the primary reflector 1 attached to the base body 3 in a suitable position, with the notches 19 fitted in the upper portions 7c of the peripheral legs 7 and the underside of the primary reflector 1 resting on the top edges 8a, 17a of the first and second connection members 8, 17 of the base body 3.

As can be seen in Fig. 4, the structural substrate of the primary reflector 1 has elastic lugs 21 formed therein projecting downwards distributed across a region around the central opening 6 and ending in second retaining claws 21a facing away from the central opening 6, and the central support 5 of the base body 3 comprises a number of side walls 5a from which a number of projections 22 protrude inwards distributed across positions corresponding to the positions of said elastic lugs 21 of the primary reflector 1. Said second retaining claws 21a have a sloping bottom surface. This way, when the primary reflector 1 is suitably placed on the base body 3 and pressed downwards, the elastic lugs 21 of the primary reflector 1 experience a deformation and subsequent elastic recovery sufficient for the second retaining claws 21a to get past the projections 22 of the central support 5 of the base body 3 and become grasped thereto (see also Fig. 2), contributing to keeping the primary reflector 1 attached to the base body 3 in a suitable position.

As shown in Figs. 1 and 2, the peripheral legs 7 of the base body have bottom ends 7a configured to lean on a base panel 14 that provides a substantially flat supporting surface, and top ends 7b configured so that hey are in contact with said transparent panel 15. Said top ends 7b of the peripheral legs 7 protrude upwards above the peripheral regions of the primary reflector 1 supported on the peripheral legs 7, such that the peripheral legs 7 of the base body 3 guarantee the distance and the parallelism between the base panel 14 and the transparent panel 17 and, since the primary reflector 1 is supported on the base body 3 and the secondary reflector 2 is supported by the transparent panel 17, the base body 3 guarantees the distance and the parallelism between the primary reflector 1 and the secondary reflector 2.

The side walls 5a of the central support 5 of the base body 3 have bottom edges on which an inner step 23 is formed (Fig. 4) configured to fit with the edges of the receiver plate 10 of the receiver unit 18 to support the receiver plate 10 in such a position that the photovoltaic cell 4 and the radiation guide will face the secondary reflector 2 through the central opening 6 of the primary reflector 1 and a rear surface of the receiver plate 10 is in contact with the base panel 14, which is preferably made of a metallic material with a high thermal conductivity coefficient so as to dissipate heat from the receiver plate 10 to said base panel 14. Thus, the base body 3 further guarantees the distance and the parallelism between the secondary reflector 2 and the photovoltaic cell 4.

The secondary reflector 2 is formed analogously to the primary reflector 1, and it comprises a structural substrate obtained by injection moulding of a plastic material that defines a convex surface and one or more metallised layers, for example of aluminium or silver, on said convex surface of the structural plastic substrate. The secondary reflector 2 is directly attached to a substantially flat underside of the transparent panel 15, for example by means of an adhesive.

In the embodiments shown, the primary reflector 1 has a square floor plan and defines four vertexes 9, on each of which one of said notches 19 is formed, and the base body 3 comprises four peripheral legs 7 in positions corresponding to said four vertexes 9. The secondary reflector 2 also has a square floor plan and is positioned with its sides parallel to the sides of the primary reflector 1. The square configuration of the primary reflector allows for the installation of a plurality of collector/concentrator units in a compact arrangement as an array using in full the available surface. Note, however, that a primary reflector with a circular or a polygonal floor plan different from the square one is also within the scope of the present invention. In case the primary reflector 1 has a polygonal floor plan, it would define, for example, a number of vertexes 9, and the base body 3 would comprise the same number of peripheral legs 7 configured and arranged so that each peripheral leg 7 would support a corresponding one of said vertexes 9. For example, a primary reflector 1 with a hexagonal floor plan would also be suitable for installing a plurality of collector/concentrator units in a compact arrangement using in full the available surface.

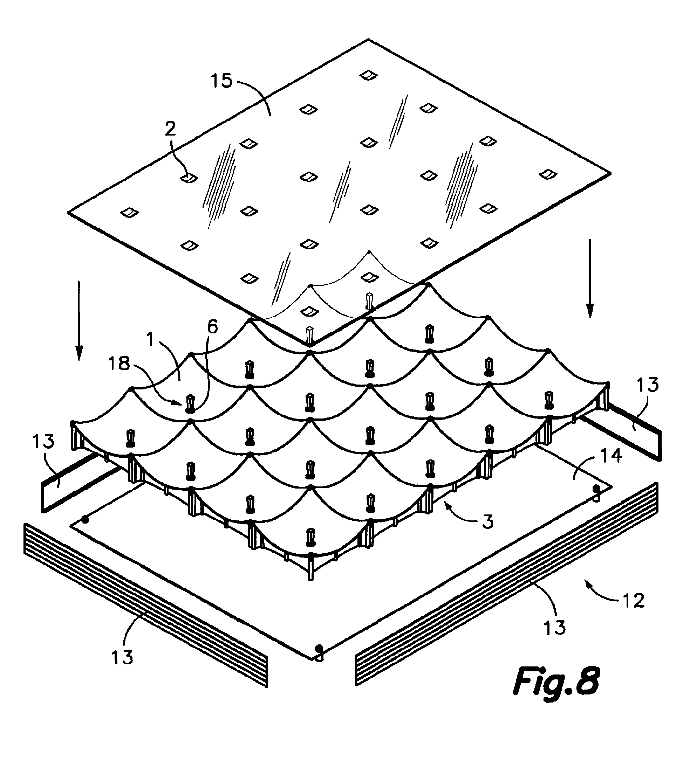

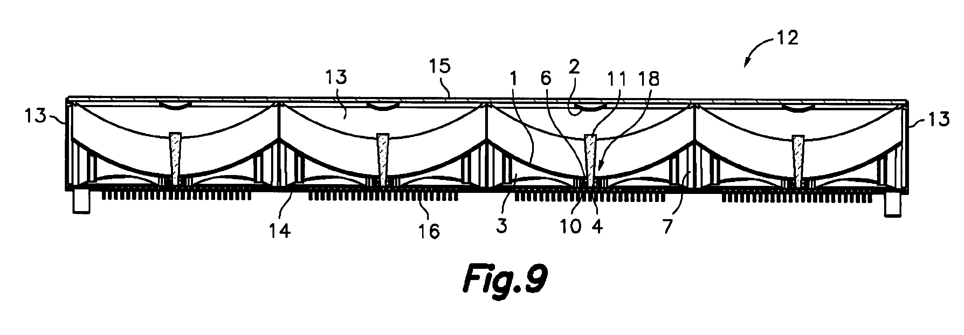

With reference now to Figs. 7, 8 and 9, a collector/concentrator is described according to another embodiment of the present invention, where a plurality of collector/concentrator units analogous to those described above in relation to Figs. 1 to 6, with the square floor plan primary reflectors 1, are arranged as an array and housed in an enclosure 12 provided with a rectangular base panel 14 that provides a substantially flat supporting surface on which the bottom ends 7a of the peripheral legs 7 of the base bodies 3 that support the primary reflectors 1 lean, a rectangular substantially flat transparent panel 15 leaning on the top ends 7b of the peripheral legs 7 of the base bodies 3, and four side walls 13 sealedly connected to said base panel 14 and to said transparent panel 15.

As shown best in Fig. 7, the upper portions 7c of the peripheral legs 7 of the base bodies have outer orthogonal surfaces parallel to the corresponding sides of the primary reflector 1 that stay clustered together when the collector/concentrator units are mutually adjacent, and the flat surfaces on the top ends 7b of the upper portions 7c are attached, for example by means of an adhesive, to an inner surface of the transparent panel 15. The secondary reflectors 2 are likewise attached, for example by means of an adhesive, to said inner surface of the transparent panel 15, in positions selected so that the secondary reflectors 2 will be suitably aligned with the corresponding primary reflectors 1 and receiver units 18. This way, the primary reflectors 1 remain positioned relative to the transparent panel 15 and the secondary reflectors 2 by the peripheral legs 7 of the base bodies 3 without the primary reflectors 1 being in contact with the transparent panel 15. The transparent panel 15, along with the base bodies 3, primary reflectors 1, secondary reflectors 2 and receiver units 18 associated thereto, is placed closing the enclosure 12 with the bottom ends 7a of the peripheral legs 7 of the base bodies 3 and the receiver plates 10 of the receiver units 18 in contact with a base panel 14. The transparent panel 15 can optionally include an antireflection treatment on one or both sides thereof.

The base panel 14 of the enclosure 12 is made of a metallic material with a high thermal conductivity coefficient and, as described above, the receiver plates 10 on which the photovoltaic cells 4 are mounted are in contact with the base panel 14 of the enclosure 12 to dissipate heat from the receiver plates 10 to the base panel 14. Preferably, the base panel 14 has a number of thermal dissipation fins 16 attached thereto or formed integrally with the material thereof. Optionally, the side walls 13 of the enclosure 12 are likewise made of a metallic material with a high thermal conductivity coefficient and their connection with the base panel 14 is of such a nature that it allows for the heat transfer from the base panel 14 to the side walls 13 to cooperate in the dissipation of heat into the atmosphere. The side walls 13 can optionally also have a number of thermal dissipation fins (not shown) attached thereto or formed integrally with the material thereof.

In an alternative embodiment (not shown), two of the opposing side walls 13 and the base panel 14 of the enclosure 12 are integrally formed as one monolithic body, whereas the other two side walls 13 are separate bodies.

Modifications and variations from the shown and described embodiments will occur to a skilled person without departing from the scope of the present invention as defined in the attached claims.

## Claims

1. A solar energy collector/concentrator with Cassegrain-type optics, including at least one collector/concentrator unit comprising a primary concave reflector (1) supported on a base body (3) and arranged to reflect solar radiation, a secondary convex reflector (2) supported by a substantially flat transparent panel (15) above said primary reflector (1) and arranged to reflect said solar radiation from the primary reflector (1), and a receiver unit (18) arranged to receive the solar radiation reflected by said secondary reflector (2) through a central opening (6) formed in the primary reflector (1) **characterised in that** the primary reflector (1) is supported on a base body (3) obtained by injection moulding, which defines a central support (5) configured to support a region around said central opening (6) of the primary reflector (1), a plurality of peripheral legs (7) configured to support respective peripheral regions of the primary reflector (1) and first integral connection members (8) connecting said peripheral legs (7) with said central support (5), the peripheral legs (7) having bottom ends (7a) configured to lean on a substantially flat supporting surface and top ends (7b) located above said peripheral regions of the primary reflector (1) and configured to be in contact with said transparent panel (15).

2. - A collector/concentrator according to claim 1 **characterised in that** said base body (3) comprises second connection members (17) connecting the mutually adjacent peripheral legs (7), the first and second connection members having respective top edges (8a, 17a) configured to be in contact with an underside of the primary reflector (1).

3. - A collector/concentrator according to claim 1 or 2 **characterised in that** said base body (3) is made of a plastic material.

4. - A collector/concentrator according to claim 1, 2 or 3 **characterised in that** the primary reflector (1) has a polygonal floor plan defining a number of vertexes (9) and the base body (3) comprises the same number of peripheral legs (7) configured and arranged such that every peripheral leg (7) supports a corresponding one of said vertexes (9).

5. - A collector/concentrator according to claim 4 **characterised in that** the primary reflector (1) has a square floor plan defining four vertexes (9) and the base body (3) comprises four peripheral legs (7).

6. - A collector/concentrator according to claim 5 **characterised in that** said secondary reflector (2) has a square floor plan.

7. - A collector/concentrator according to any one of claims 1 to 6 **characterised in that** said receiver unit (18) comprises a photovoltaic cell (4) mounted, together with electric and electronic components, on a receiver plate (10) and the central support (5) of the base body (3) is configured to support said receiver plate (10) in such a position that the photovoltaic cell (4) is facing said secondary reflector (2) through said central opening (6) of the primary reflector (1) and a back surface of the receiver plate (10) is in contact with a base panel (14) providing said substantially flat supporting surface to dissipate heat from the receiver plate (10) to said base panel (14).

8. - A collector/concentrator according to claim 7 **characterised in that** the receiver unit (18) further comprises a radiation guide (11) supported on said receiver plate (10) and drawn through the central opening (6) of the primary reflector (1) to remain interposed between the secondary reflector (2) and the photovoltaic cell (4).

9. - A collector/concentrator according to claim 8 **characterised in that** said radiation guide (11) comprises a solid frustopyramidal block made of a transparent material provided with a base surface attached to the photovoltaic cell (4) by means of a transparent adhesive.

10. - A collector/concentrator according to claim 9 **characterised in that** the radiation guide (11) is made of BK7 glass.

11. - A collector/concentrator according to claim 8, 9 or 10 **characterised in that** the upper region of said radiation guide (11) is held by a frame (25) from which a number of legs (26) attached to said receiver plate (10) or to the base body (3) project.

12. - A collector/concentrator according to any one of the preceding claims **characterised in that** the primary reflector (1) comprises a structural substrate obtained by injection moulding of a plastic material and metallised on the concave surface thereof.

13. - A collector/concentrator according to claim 12 **characterised in that** said structural substrate of the primary reflector (1) and said base body (3) defme respective first mutual snap lock coupling configurations in said region around the central opening (6) of the primary reflector (1) and on the central support (5) of the base body (3) and respective second mutual snap lock coupling configurations in said peripheral regions of the primary reflector (1) and in the peripheral legs (7) of the base body (3).

14. - A collector/concentrator according to any one of the preceding claims **characterised in that** the secondary reflector (2) comprises a structural substrate obtained by injection moulding of a plastic material and metallised on the convex surface thereof.

15. - A collector/concentrator according to any one of the preceding claims **characterised in that** it comprises a plurality of said collector/concentrator units arranged as an array and housed in an enclosure (12) comprising side walls (13) attached to a base panel (14) that provides said substantially flat surface on which said bottom ends (7a) of the peripheral legs (7) of the base bodies (3) of the primary reflectors (1) lean, and to said substantially flat transparent panel (15) leaning on said top ends (7b) of the peripheral legs (7) of the base bodies (3) of the primary reflectors (1) and on which the secondary reflectors (4) are supported, where the receiver plates (10) on which the photovoltaic cells (4) are mounted are in contact with the base panel (14) of the enclosure (12) so as to dissipate heat from the receiver plates (10) to the base panel (14).

16. - A collector/concentrator according to claim 15 **characterised in that** said top ends (7b) of the peripheral legs (7) of the base bodies (3) of the secondary reflectors (4) are attached to the inner surface of the transparent panel (15).

17. - A collector/concentrator according to claim 15 **characterised in that** the base panel (14) of the enclosure (12) is made of a metallic material with a high thermal conductivity coefficient.

18. - A collector/concentrator according to claim 17 **characterised in that** the side walls (13) of the enclosure (12) are made of a metallic material with a high thermal conductivity coefficient and are attached to the base panel (14) to receive heat from the base panel (14) and dissipate it into the atmosphere.

19. - A collector/concentrator according to claim 17 or 18 **characterised in that** a number of thermal dissipation fins (16) are attached to the base panel (14) and/or to the side walls (13) of the enclosure (12).

20. - A collector/concentrator according to claim 1 or 15 **characterised in that** said transparent panel (15) comprises an antireflection treatment on one or both sides thereof.

21. - A collector/concentrator according to any one of the preceding claims **characterised by** meeting the following parameters:
- a geometric concentration defined as the ratio of an aperture surface of the primary reflector (1) and a receiver surface of the photovoltaic cell (4), comprised in the range of 1470/1 to 1490/1;
- a ratio of the floor plan area of the primary reflector (1) to the floor plan area of the secondary reflector (2), comprised in the range of 42/1 to 44/1; and
- a ratio of the floor plan area of the primary reflector (1) to the distance between the primary reflector (1) and the secondary reflector (2), measured along the optical axis, comprised in the range of 655/1 to 685/1.
